# FASCICULE DE BREVET EUROPEEN

(11) **EP 2 022 588 B1**
(45) Date de publication et mention de la délivrance du brevet: **06.10.2010**
(21) Numéro de dépôt: 08305272.0
(22) Date de dépôt: 17.06.2008
(51) Int. Cl.: B23K 1/00, B23K 1/20, H01L 21/60

(54) **Procédé de soudure de deux éléments entre eux au moyen d'un matériau de brasure**
Verfahren zum Verschweißen von zwei Teilen mit Hilfe eines Lötmaterials
Method of welding two elements together by means of a brazing material

(30) Priorité: 23.07.2007 FR 0705329
(43) Date de publication de la demande: 11.02.2009
(73) Titulaire: Commissariat à l'Énergie Atomique et aux Énergies Alternatives, 75015 Paris (FR); Photonera France, 31240 L'Union (FR)
(72) Inventeur: Kopp, Christophe, 38120 Fontanil-Cornillon (FR); Bablet, Jacqueline, 38450 Le Gua (FR); Raby, Jacques, 38000 Grenoble (FR); Rossat, Cyrille, 38590 St Etienne de St Geoirs (FR)
(74) Mandataire: Vuillermoz, Bruno

(56) Documents cités:
- DE-A1- 10 332 827
- JP-A- 4 029 308

## Description

La présente invention concerne le domaine de la microélectronique, et plus particulièrement celui des techniques d'hybridation par billes de deux composants hétérogènes, également appelées billes de brasure. Elle se rattache donc au domaine général des microcomposants, plus classiquement dénommés puces électroniques, mais est également susceptible de s'appliquer aux micro capteurs, micro actuateurs, tels que les MEMS (selon l'expression anglo-saxonne « *Micro Electro Mecanicals Systems* »), également aux composants optoélectroniques, du type VCSEL (pour l'expression anglo-saxonne « V*ertical Cavities Semi Conductor Emitting Laser »*) etc...

Au sens de l'invention, on entend par composant, un capteur électronique, tel qu'une puce électronique, un support de circuit électrique ou électronique, ou encore un composant électrique passif du type capot de protection, voire même un capteur de grandeur physique.

### ETAT ANTERIEUR DE LA TECHNIQUE

Les microcomposants dont il est question dans le cadre de la présente invention sont classiquement déposés sur un substrat de nature appropriée, par exemple de type semi-conducteur (silicium monocristallin, saphir, etc...) pour des composants électroniques.

Un tel substrat est muni de pistes conductrices de l'électricité, par exemple réalisées en aluminium, qui rayonnent à partir du microcomposant en direction de la périphérie du substrat, afin de permettre, outre l'alimentation électrique du composant, le cas échéant requise, également et surtout le traitement de l'exploitation des signaux que ledit composant est appelé à générer, voire le pilotage des fonctions qu'il incorpore.

Pour assembler différents composants entre eux, l'une des techniques aujourd'hui largement répandue est celle de l'hybridation par billes dite «*flip chip* ». Cette technologie consiste succinctement :
- à déposer sur une ou plusieurs surfaces mouillables, mises en places sur l'un des composants à assembler, le matériau constitutif des billes de soudure selon une quantité appropriée ;
- à munir l'autre composant à hybrider de surfaces mouillables par ledit matériau de soudure, lesdites surfaces étant ménagées sensiblement à l'aplomb des surfaces dudit premier composant lorsque le second composant est reporté sur le premier ;
- à déposer un flux de matériau se présentant sous forme liquide, ledit flux remplissant une fonction chimique de désoxydation et d'empêchement de la ré-oxydation pendant la brasure, une fonction thermique permettant d'assurer le transfert de chaleur, et une fonction physique permettant de diminuer les tensions de surface et dès lors de favoriser la formation des billes proprement dites ;
- puis, à mettre en contact la surface de mouillabilité de l'autre composant avec le matériau de brasure ainsi déposé ;
- et enfin, à élever la température jusqu'à atteindre une température supérieure à la température de fusion du matériau constitutif des billes pour obtenir la fusion de celles-ci jusqu'à aboutir au résultat recherché, à savoir l'hybridation du premier composant sur le second composant, lesdites billes créant un lien mécanique et/ou électrique entre les surfaces mouillables de chacun des composants, l'une au moins desdites surfaces mouillables étant elles-mêmes reliées aux pistes conductrices ménagées sur ce dernier.

Ainsi, au cours du procédé d'assemblage, le matériau de brasure constitutif des billes adopte-il la forme d'une bille.

Or, la brasure de l'indium, matériau classiquement rencontré pour réaliser ces billes, sur une surface mouillable, elle-même classiquement réalisée en or, nécessite la mise en oeuvre d'agents désoxydants liquides ou gazeux, en l'espèce le flux liquide également dénommé flux de soudure.

Par nature, ces flux de soudure sont généralement corrosifs, et après réduction de l'oxyde, sont susceptibles d'attaquer également le coeur du métal de soudure.

Or, l'expérience démontre que cette corrosion indésirable est aggravée par deux configurations particulières :
- un effet pile résultant de la mise en oeuvre de couple de métaux de potentiel électrochimique différents en présence du flux de soudure, ce dernier faisant fonction d' électrolyte ;
- la durée excessive de contact entre les billes de soudure et le flux.

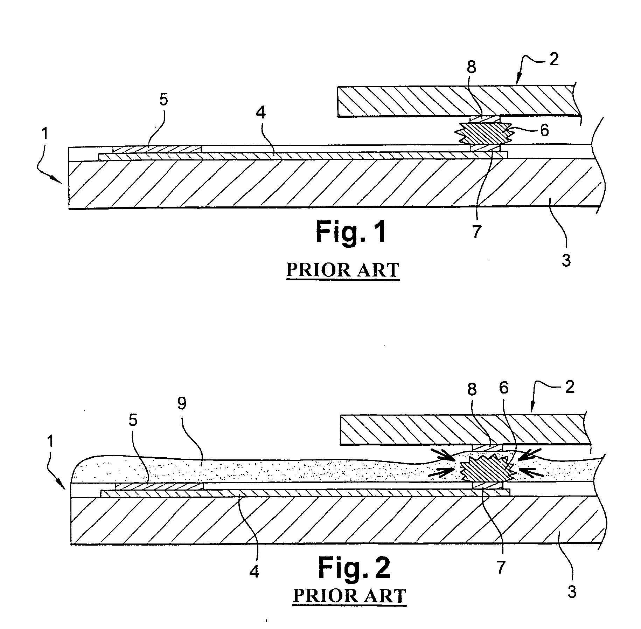

L'effet pile peut être explicité de la manière suivante, en relation avec les figures 1 et 2, décrivant schématiquement l'hybridation *flip chip,* conforme à l'état antérieur de la technique. On a représenté sur celles-ci un premier composant **1** sur lequel est hybridée une puce **2.**

Le composant **1** comporte un substrat hôte **3,** tel que du silicium, sur lequel sont réalisées des pistes conductrices **4** par exemple réalisées en aluminium. A l'aplomb des zones d'hybridation, sont réalisés respectivement sur le substrat **3** et sur la puce à hybrider **2** des surfaces mouillables **7** et **8,** également dénommées UBM selon l'expression anglo-saxonne « *Under Bump Metalization* », et typiquement réalisées en or.

Parallèlement, le composant **1** comporte également une pluralité de plots de connexion externe **5.** Ces plots sont en fait constitués d'une surface électriquement conductrice, apte à assurer le relais pour la connexion entre le composant à hybrider et l'extérieur. Un tel plot est classiquement constitué d'une surface métallique sur laquelle est éventuellement thermo-compressé un fil conducteur typiquement réalisé en or.

Lors de l'hybridation, on étale sur tout le composant **1** après dépôt du matériau de brasure ou de soudure destiné à constituer la bille d'hybridation **6** un désoxydant **9** (figure 2), qui vient de fait recouvrir à la fois le plot de connexion externe **5** et la bille d'hybridation **6.** Le matériau constituant cette dernière est le plus souvent réalisé en indium, en alliage étain/plomb ou en alliage sans plomb comme AgCuSn.

Ainsi, la couche d'or du plot de connexion externe **5** est reliée par une connexion électrique constituée par la piste d'aluminium **4** à la bille de soudure **6,** de sorte qu'en raison de la présence du flux de soudure **9** faisant alors fonction d'électrolyte, il se crée un circuit électrique fermé, engendrant un phénomène électrochimique aboutissant à la réduction du matériau constitutif de la bille d'hybridation, selon le principe bien connu des piles électrochimiques, et ce en raison des potentiels électrochimiques différents des métaux mis en oeuvre. Ce faisant, on observe la réduction du matériau constitutif de la bille, aboutissant à sa dissolution à tout le moins partielle dans le flux de soudure et par voie de conséquence, à l'altération de l'hybridation recherchée entre la puce **2** et le composant **1.**

Afin de surmonter cet inconvénient, on a tout d'abord proposé soit de recouvrir les plots de connexion externes avec une couche isolante, par exemple en résine afin de l'isoler du circuit électrochimique précédemment décrit, soit de remplacer l'or du plot de connexion externe par un métal ayant le même potentiel électrochimique que le matériau constitutif de la bille. Cependant, ces deux solutions conduisent à une complexification du procédé de fabrication du circuit hôte, en l'espèce du composant, ne serait-ce qu'en raison d'une étape supplémentaire aboutissant outre à une perte en termes de rendement de fabrication, également un surcoût de fabrication.

On a également proposé de mettre en oeuvre une protection cathodique :
- soit par dépôt d'une anode sacrificielle, et basée sur le principe de la corrosion bimétallique ; un métal est connecté au métal à protéger et ce métal rajouté se corrode alors en lieu et place de la structure métallique ;
- soit par la méthode dite de soutirage du courant, qui nécessite alors la mise en oeuvre d'une alimentation électrique continue. La structure à protéger est dans ce cas connectée à la borne négative d'un générateur de courant continu, réglé de manière à maintenir la structure à protéger dans sa zone d'immunité.

Dans un cas comme dans l'autre, la protection cathodique complexifie le procédé de fabrication, outre dans le dernier cas, la gestion des entrées et sorties du signal.

Il convient cependant de souligner que ce problème technique inhérent à la consommation électrochimique du matériau constitutif des billes d'hybridation n'est pas réellement critique si l'hybridation en tant que telle est susceptible d'être réalisée dans un temps réduit.

Cependant, lesdites opérations d'hybridation tendent à devenir systématiquement collectives, afin de réduire les coûts de fabrication. Ainsi, on hybride par la technique de refusion collective des composants déposés par centaine, voire par millier sur un substrat hôte. La séquence d'hybridation correspondante peut alors durer plusieurs heures et dans cette hypothèse, ne peut plus s'accommoder des phénomènes de corrosion ou de consommation électrochimique précédemment décrits, qui s'amplifient avec le facteur temps.

On a également proposé de réaliser le brasage sous flux gazeux. Dans cette hypothèse, des flux gazeux peuvent être utilisés pour assurer le brasage tendre. Ce faisant, lors de l'étape de report des composants l'un sur l'autre en vue d'assurer leur hybridation, il n'y a pas d'électrolyte reliant électriquement les billes et les contacts métalliques. Parmi les flux gazeux connus, on connaît le mélange N₂ +HCOOH ou N₂H₂. Cependant, ces gaz ont des températures d'activation plutôt élevées respectivement plus de 200°C et plus de 350°C. Ces montées en température peuvent constituer un inconvénient, étant rappelé que pour l'indium, un cycle thermique de brasage avec un bref pic à 170-180°C est suffisant.

L'objectif recherché par la présente invention est de s'affranchir de ces différents problèmes techniques sans pour autant complexifier le procédé d'hybridation.

### EXPOSE DE L'INVENTION

Elle vise ainsi un procédé de soudure ou d'hybridation de deux composants entre eux au moyen d'un matériau de brasure, l'un au moins desdits composants, dénommé ci-après premier composant, comportant une ou plusieurs pistes métalliques électriquement conductrices, reliées à autant de plots de connexion externe.

Ce procédé consiste :
- à réaliser sur les surfaces en regard des composants à souder ou à hybrider une surface de mouillabilité dudit matériau de brasure, celle réalisée sur ledit premier composant étant en contact électrique avec une piste métallique ;
- à déposer sur l'une desdites surfaces de mouillabilité une quantité appropriée de matériau de brasure, propre à constituer un plot de soudure ou d'hybridation ;
- à déposer un flux de matériau sous forme liquide remplissant les fonctions de désoxydation et de limitation de ré-oxydation dudit matériau de brasure après réalisation effective de ladite brasure, de transfert de chaleur, outre de diminution des tensions de surface ;
- à mettre en contact la surface de mouillabilité de l'autre composant avec le matériau de brasure ainsi déposé ;
- puis à élever la température de l'enceinte au sein de laquelle sont positionnés les composants à souder ou à hybrider jusqu'à atteindre au moins la température de fusion du matériau de brasure afin d'assurer la soudure ou l'hybridation effective des deux composants entre eux par effet de refusion.

Selon l'invention, ce procédé consiste à définir des zones de mouillabilité différenciées vis à vis du flux liquide de soudure, de telle sorte à isoler au moins électriquement les volumes de flux en contact avec les zones dudit premier composant recevant le matériau de brasure et celles définies par le ou les plots de connexion externe.

En d'autres termes, l'invention consiste à créer une discontinuité électrique au niveau du flux de soudure entre une zone spécifique au niveau de laquelle est positionné le matériau de brasure, et les plots de connexion externe, afin d'interdire la réaction électrochimique inhérente aux potentiels redox différents des métaux mis en oeuvre.

Selon un mode particulier de réalisation de l'invention, on définit même sur ledit premier composant une zone non mouillable vis-à-vis du flux de soudure, par exemple réalisée par dépôt d'un revêtement anti-mouillant, de faible épaisseur. Ce revêtement est par exemple constitué de SiOC ou de C₄F₈.

Cette zone de faible ou de non mouillabilité vis-à-vis du flux peut être située à l'aplomb des plots externes ou, entre les zones de réception du matériau de brasure et lesdits plots externes.

### DESCRIPTION DES FIGURES

La manière dont l'invention peut être réalisée et les avantages qui en découlent, ressortiront mieux des exemples de réalisation qui suivent, donnés à titre indicatif et non limitatif, à l'appui des figures annexées.
Les figures 1 et 2 sont, comme déjà dit, des représentations schématiques du principe d'hybridation selon l'état antérieur de la technique.
La figure 3 est une vue latérale du procédé d'hybridation conforme à l'invention, selon un premier mode de réalisation, la figure 4 étant une vue du dessus.
Les figures 5 et 6 sont des vues analogues aux figures 3 et 4 d'un second mode de réalisation de l'invention.

### DESCRIPTION DETAILLEE DES MODES DE REALISATION DE L'INVENTION

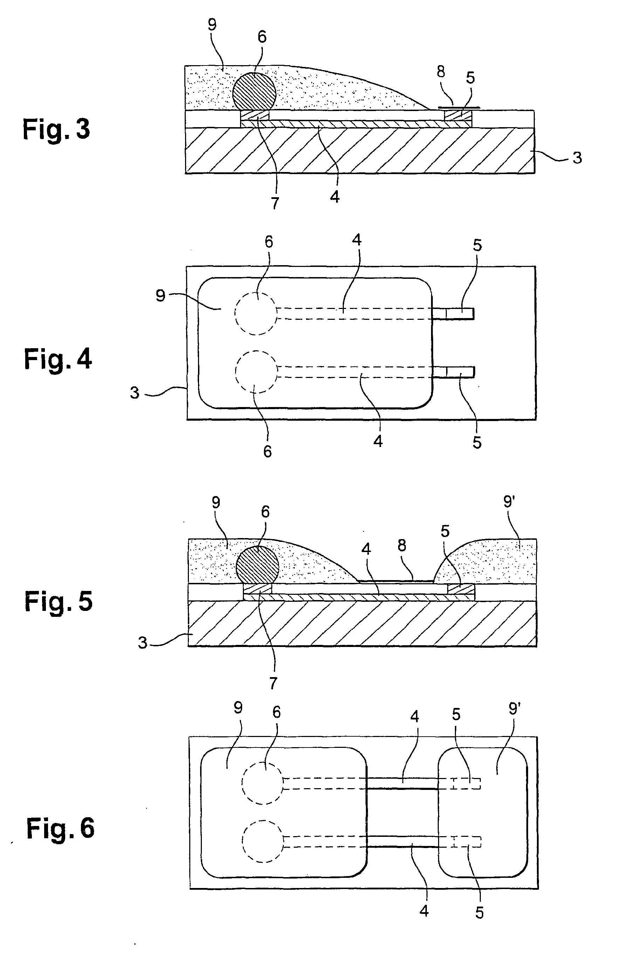

Le procédé d'hybridation conforme à l'invention est plus particulièrement décrit en relation avec les figures 3 à 6.

Celles-ci représentent l'hybridation d'une puce électronique **2** sur un composant électronique **1.** Celui-ci, à l'instar de la description des figures 1 et 2, comporte fondamentalement un substrat **3,** également dénommé substrat hôte. Celui-ci est typiquement réalisé en un matériau semi-conducteur et notamment en silicium monocristallin. Sur ce substrat **3,** sont ménagées un certain nombre de pistes électriquement conductrices **4,** destinées à permettre, dans le cas présent, la transmission des signaux électriques émanant de la puce **2** vers l'extérieur, en vue de leur traitement. Ces pistes électriques sont par exemple réalisées en aluminium et aboutissent à un ou plusieurs plots de connexion externe **5.**

De tels plots de connexion externe supposent la mise en oeuvre d'une couche localisée favorisant la condition électrique, et en l'espèce, sont constitués par un fil d'or.

Les billes d'hybridation assurant la connectique, également dénommées « billes utiles », sont typiquement réalisées par dépôt d'une quantité de matériau de brasure **6** et notamment d'indium au niveau d'une zone de mouillabilité **7,** également réalisé en or, et positionnée en contact avec les pistes conductrices **4** au lieu choisi de l'hybridation. De manière connue, la puce **2** comporte également une telle zone de mouillabilité, mais que l'on n'a pas fait figurer en relation avec les figures 3 à 6 puisque seule la partie inférieure du composant, c'est-à-dire le substrat, a été représentée.

On peut également revêtir le substrat muni des pistes conductrices d'une couche de passivation en SiO₂ ou Si₃N₄.

Selon une première caractéristique de l'invention, on dépose sur le plot de connexion externe **5** un revêtement **8** présentant une absence de mouillabilité vis à vis du flux de brasure mis en oeuvre lors de l'étape d'hybridation. Ce revêtement est de faible épaisseur, typiquement comprise entre 10 et 500 nm, et est par exemple constitué de SiOC ou de C₄F₈.

Ce faisant, lors du dépôt du flux de brasure **9,** celui-ci ne recouvre pas la zone de non-mouillabilité **8** et, par voie de conséquence, ne rentre pas en contact avec le plot de connexion externe **5.**

Afin de s'assurer que ledit flux de brasure **9** n'entre pas en contact avec le plot de connexion externe **5,** le revêtement de non mouillabilité vis-à-vis du flux de brasure **8** présente une surface supérieure à celle du plot de connectique externe **5.**

Ce faisant, il ne peut donc plus y avoir fermeture de circuit électrique constitué par les plots de connexion externe **5,** les pistes métalliques **4,** les billes d'hybridation **6** et le flux de brasure **9.** Par voie de conséquence, il ne peut donc se produire une quelconque réaction électrochimique entre ces différents éléments dans lesquels le flux de brasure **9** serait susceptible de remplir le rôle d'électrolyte, et dont on en a montré dans la description de l'art antérieur, le phénomène corrosif vis-à-vis de l'indium constitutif desdites billes **6.**

La protection du plot de connexion externe **5** par ce revêtement de faible ou d'absence de mouillabilité **8** n'est pas impérative. Le caractère impératif repose sur l'absence de contact électrique entre le plot de connexion externe et le flux de brasure en contact avec les billes d'hybridation.

Ainsi, dans une variante de l'invention représentée en relation avec les figures 5 et 6, on observe que le flux de brasure se divise en deux parties **9** et **9'** indépendantes l'une de l'autre, ladite partie **9'** venant recouvrir les plots de connexion externes **5.** Dans cette hypothèse, le revêtement de non-mouillabilité **8** est positionné entre lesdits plots de connexion externe **5** et les billes d'hybridation **6.**

On conçoit de fait tout l'intérêt du procédé conforme à l'invention.

Tout d'abord, on élimine tout risque de corrosion des billes d'hybridation **6** en raison de la suppression de la réaction électrochimique précitée et ce, quelle que soit la durée de mise en oeuvre pour hybrider les composants. Au surplus, ce procédé permet la mise en oeuvre du flux liquide de brasure ou d'hybridation, et par voie de conséquence, la mise en oeuvre d'une température d'hybridation basse, nécessaire dès lors que l'indium est utilisé comme matériau de brasure.

Par ailleurs, on conçoit également que ce procédé d'hybridation n'engendre pas de complexification particulière par rapport aux procédés de l'état antérieur de la technique, celui-ci se résumant par le dépôt de la fine couche du revêtement de faible ou d'absence de mouillabilité vis-à-vis du flux de soudure.

Le dépôt de ce revêtement est par exemple réalisé par PECVD (pour l'expression anglo-saxone «*Plasma Enhanced Chemical Vapor Deposition*» à partir d'un précurseur, en l'espèce l'OMCTS pour «*Octamethylcyclotetrasiloxane»)* et en utilisant un gaz porteur tel que l'argon ou l'hydrogène.

Selon la puissance du plasma, la pression, la concentration initiale en précurseur et la durée du dépôt plasma, on peut contrôler l'épaisseur de la couche déposée et sa stoechiométrie SiOₓ₁C_{y1}H_{z1}. Le matériau SiOₓ₁C_{y1}H_{z1} est de formulation telle que 0,3 ≤ x 1 ≤ 0,4 et 0,15 ≤ yl ≤ 0,2 et 0,4 ≤ z1 ≤ 0,55.

Bien évidemment, ce procédé de dépôt et les traitements correspondants peuvent être généralisés à d'autres types de siloxanes de formulation proche, tel que par exemple le TNCTS pour « *tétraéthylcyclotetrasiloxane* ».

Ce matériau peut en outre être traité et transformé en surface en un matériau de formulation générale SiOₓ₂C_{y2}H_{z2}, avec x₂>>x₁, y₂<<y₁ et z₂<<z₁, ou plus simplement SiOₓ, dans lequel x tend vers 2 pour notamment augmenter la valeur de son énergie de surface, en particulier polaire, et induire une très forte mouillabilité des liquides (de l'ordre de 5° d'angle de contact pour l'eau), et une très forte augmentation de l'adhérence et du développement cellulaire (passage d'un temps de génération de 40 heures sur OMCTS brut à 20 heures sur de l'OMCTS traité).

Les traitements utilisés sont soit de type plasma, à savoir un plasma d'hélium ou des plasmas d'oxygène 0₂, SF₆ + O₂, CHF₃ +O₂ ...), soit de type UV dans l'air ambiant ou dans une atmosphère enrichie en oxygène.

Ce procédé offre donc la possibilité de localiser aisément par traitement, en utilisant soit des masques mécaniques soit des masques optiques, des zones de forte énergie de surface. Ce faisant, cela permet de localiser des gouttelettes d'espèces chimiques variées, des liquides peu visqueux (eau, molécules biologiques, huile) à visqueux (colle, résine, peinture) sur un motif déterminé par le masque, et d'autre part, de localiser l'adhérence de cellules vivantes (et l'adsorption de molécules biologiques) dans ces zones.

On conçoit tout l'intérêt du procédé de l'invention, dans la simplification des moyens à mettre en oeuvre pour assurer l'hybridation entre deux composants.

## Revendications

1. Procédé de soudure ou d'hybridation de deux composants entre eux au moyen d'un matériau de brasure, l'un au moins desdits composants, dénommé ci-après premier composant (3), comportant une ou plusieurs pistes métalliques (4) électriquement conductrices, reliées à autant de plots de connexion externe (5), consistant :
- à réaliser sur les surfaces en regard des composants à souder ou à hybrider une surface de mouillabilité dudit matériau de brasure, celle réalisée sur ledit premier composant (3) étant en contact électrique avec une piste métallique (4) ;
- à déposer sur l'une desdites surfaces de mouillabilité une quantité appropriée de matériau de brasure, propre à constituer un plot de soudure ou d'hybridation (6) ;
- à déposer un flux (9) de matériau sous forme liquide remplissant les fonctions de désoxydation et de limitation de ré-oxydation dudit matériau de brasure après réalisation effective de ladite brasure, de transfert de chaleur, outre de diminution des tensions de surface ;
- à mettre en contact la surface de mouillabilité de l'autre composant avec le matériau de brasure ainsi déposé ;
- puis à élever la température de l'enceinte au sein de laquelle sont positionnés les composants à souder ou à hybrider jusqu'à atteindre au moins la température de fusion du matériau de brasure afin d'assurer la soudure ou l'hybridation effective des deux composants entre eux par effet de refusion ;
***caractérisé* en ce qu'**il consiste en outre à définir sur ledit premier composant (3) des zones de mouillabilité différenciées vis à vis du flux liquide de soudure, de telle sorte à isoler au moins électriquement les volumes de flux en contact avec les zones dudit premier composant recevant le matériau de brasure et celles définies par le ou les plots de connexion externe (5).

2. Procédé de soudure ou d'hybridation selon la revendication 1, ***caractérisé en* ce que** les zones de mouillabilité différenciées résultent du dépôt sur ledit premier composant d'un revêtement anti-mouillant (8) de faible épaisseur.

3. Procédé de soudure ou d'hybridation selon la revendication 2, ***caractérisé* en ce que** le revêtement (8) est constitué de SiOC ou de C₄F₈.

4. Procédé de soudure ou d'hybridation selon l'une des revendications 2 et 3, ***caractérisé* en ce que** le revêtement (8) est déposé par PECVD.

5. Procédé de soudure ou d'hybridation selon l'une des revendications 2 à 4, ***caractérisé* en ce que** le revêtement (8) est déposé à l'aplomb des plots de soudure externe (5).

6. Procédé de soudure ou d'hybridation selon l'une des revendications 2 à 4, ***caractérisé* en ce que** le revêtement (8) est déposé entre les zones de réception du matériau de brasure (6) et les plots de connexion externe (5).

## Claims

1. A method for soldering or hybridizing two components to each other by means of a solder material, at least one of said components, referred to hereinafter as the "first component" (3), comprising one or more metallic conductors (4) linked to an equal number of external bonding pads (5) which involves:
- producing, on the opposite-facing surfaces of the components to be soldered or hybridized, a surface capable of being wetted by said solder material, this surface being produced on said first component (3) which is in electrical contact with a metallic conductor (4);
- depositing an appropriate quantity of solder material capable of constituting a solder or hybridization pad (6) on one of said wettability surfaces;
- depositing a flux (9) material in liquid form having the following functions: deoxidizing and limiting the reoxidation of said solder material after actually producing said soldered joint, transferring heat and reducing the surface tension;
- bringing the wettability surface of the other component into contact with the solder material thus deposited;
- then raising the temperature of the chamber in which the components to be soldered or hybridized are placed until at least the melting temperature of the solder material is reached in order to ensure effective soldering or hybridization of the two components to each other due to the reflow effect;
***characterized* in that** it also involves defining, on said first component (3), wettability areas which are differentiated in terms of the liquid solder flux so as to insulate, at least electrically, the volumes of flux which are in contact with those areas of said first component which receive the solder material and those defined by the external bonding pad or pads (5).

2. A method for soldering or hybridizing as claimed in claim 1, ***characterized* in that** the differentiated wettability areas are the result of depositing a thin anti-wetting coating (8) on said first component.

3. A method for soldering or hybridizing as claimed in claim 2, ***characterized* in that** coating (8) consists of SiOC or C₄F₈.

4. A method for soldering or hybridizing as claimed in any of claims 2 and 3, ***characterized* in that** coating (8) is deposited by PECVD.

5. A method for soldering or hybridizing as claimed in any of claims 2 to 4, ***characterized* in that** coating (8) is deposited vertically above external bonding pads (5).

6. A method for soldering or hybridizing as claimed in any of claims 2 to 4, ***characterized* in that** coating (8) is deposited between the areas which receive solder material (6) and external bonding pads (5).

## Patentansprüche

1. Verfahren, zum Zusammenlöten und Hybridisieren zweier Bauteile mittels eines Lötmittels, wobei mindestes eines der Bauteile, im Nachstehenden erstes Bauteil (3) genannt, eine oder mehrere elektrisch leitende Metallbahn/en (4) umfasst, die an ebenso viele externe Anschlusskontakte (5) angeschlossen sind, darin bestehend:
- auf den Flächen, die den zu verlötenden oder zu hybridisierenden Bauteilen zugewandt sind, eine mit dem Lötmittel benetzbare Fläche auszubilden, wobei diejenige Fläche, die auf dem ersten Bauteil (3) ausgebildet wird, in elektrischem Kontakt mit einer Metallbahn (4) ist;
- auf einer der benetzbaren Flächen eine zweckmäßige Menge an Lötmittel abzuscheiden, die geeignet ist, einen Löt- oder Hybridisierungskontakt (6) zu bilden;
- einen Materialfluss (9) in flüssiger Form abzuscheiden, der die Aufgaben einer Desoxidation und einer Reoxidationsbegrenzung des Lötmittels nach der effektiven Herstellung der Lötverbindung, der Wärmeübertragung, und zudem einer Minderung der Oberflächenspannungen erfüllt,
- die benetzbare Fläche des anderen Bauteils mit dem so abgeschiedenen Lötmittel in Kontakt zu bringen;
- dann die Temperatur der Umschließung, in der die zu verlötenden oder zu hybridisierenden Bauteile positioniert sind, auf mindestens die Schmelztemperatur des Lötmittels anzuheben, um die effektive Verlötung oder Hybridisierung der beiden Bauteile miteinander durch Wiederaufschmelzen sicherzustellen;
**dadurch gekennzeichnet, dass** es darüber hinaus darin besteht, auf dem ersten Bauteil (3) Zonen unterschiedlicher Benetzbarkeit, die sich gegenüber dem flüssigen Lötmittelfluss auszubilden, und zwar so, dass die Flussvolumen, die mit den Zonen des ersten Bauteils in Kontakt sind, die das Lötmittel aufnehmen, und diejenigen, die durch den bzw. die externen Anschlusskontakt/e (5) gebildet sind, wenigstens elektrisch isoliert werden.

2. Löt- oder Hybridisierungsverfahren nach Anspruch 1, **dadurch gekennzeichnet, dass** die sich die Zonen unterschiedlicher Benetzbarkeit aus der Abscheidung einer benetzungsverhindernden Beschichtung (8) geringer Dicke auf dem ersten Bauteil ergeben.

3. Löt- oder Hybridisierungsverfahren nach Anspruch 2, **dadurch gekennzeichnet, dass** die Beschichtung (8) aus SiOC oder C₄F₈ besteht.

4. Löt- oder Hybridisierungsverfahren nach einem der Ansprüche 2 und 3, **dadurch gekennzeichnet, dass** die Beschichtung (8) durch PECVD abgeschieden wird.

5. Löt- oder Hybridisierungsverfahren nach einem der Ansprüche 2 bis 4, **dadurch gekennzeichnet, dass** die Beschichtung (8) senkrecht zu den externen Lötkontakten (5) abgeschieden wird.

6. Löt- oder Hybridisierungsverfahren nach einem der Ansprüche 2 bis 4, **dadurch gekennzeichnet, dass** die Beschichtung (8) zwischen den Aufnahmezonen des Lötmittels (6) und den externen Anschlusskontakten (5) abgeschieden wird.
